(19) Europäisches Patentamt
European Patent Office
Office européen des brevets

(11) EP 3 537 163 A1

(12) **EUROPEAN PATENT APPLICATION**
published in accordance with Art. 153(4) EPC

(43) Date of publication:
**11.09.2019 Bulletin 2019/37**

(51) Int Cl.:
***G01R 11/02*** (2006.01)     ***G01R 11/24*** (2006.01)
***G01R 22/06*** (2006.01)

(21) Application number: **17867796.9**

(22) Date of filing: **20.09.2017**

(86) International application number:
**PCT/JP2017/033856**

(87) International publication number:
**WO 2018/083902 (11.05.2018 Gazette 2018/19)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **01.11.2016 JP 2016214657**

(71) Applicant: **Omron Corporation
Kyoto-shi, Kyoto 600-8530 (JP)**

(72) Inventor: **SATO, Masashi
Ichinomiya-shi
Aichi 491-0201 (JP)**

(74) Representative: **Kilian Kilian & Partner
Aidenbachstraße 54
81379 München (DE)**

(54) **ELECTRICITY METER AND ELECTRICITY METER FIRE OUTBREAK LOCATION IDENTIFICATION METHOD**

(57) The present invention provides an energy meter and an energy meter fire outbreak location identification method, each of which can (i) determine whether a temperature rise of an energy meter main body results from a fire outbreak from outside the energy meter main body or a fire outbreak from inside the energy meter main body and (ii) retain a result of the determination. The energy meter 1A for accumulating power consumption includes: an internal measurement-use temperature sensor (25) configured to detect a rise in an internal temperature of the energy meter main body; an abnormality determination control section (13c) configured to determine, on the basis of a rate of the rise in the internal temperature, whether the rise in the internal temperature results from a fire outbreak from outside the energy meter main body or a fire outbreak from inside the energy meter main body; and an external communication section (14) configured to transmit a result of the determination made by the abnormality determination control section (13c) to an outside entity.

FIG. 1

EP 3 537 163 A1

**Description**

Technical Field

The present invention relates to an energy meter and an energy meter fire outbreak location identification method which can prevent fraudulent activities.

Background Art

Conventionally, there have been wrongdoers who commit electricity theft (steal electricity) by tampering with energy meters.
Electricity theft through tampering with an energy meter is committed by, for example, setting fire to the energy meter so as to delete a record of power consumption for which a user should be charged.
An energy meter is burned by, for example, (i) a method in which a display section of an energy meter, such as a liquid crystal display (LCD) display section for displaying the power consumption, is intensively burned so as to make it impossible to read the display section or (ii) a method in which an energy meter is completely burned in its entirety.
Power supply companies file claims for damages against those who have committed such fraud. In many cases, however, it is not possible to identify the amount of compensation because the evidence such as the record of power consumption is burned. In many cases of electricity theft by burning energy meters, in particular, wrongdoers make such false accusation that the energy meters caught fire from inside due to malfunction.
Conventionally, Patent Literature 1, for example, discloses an energy meter which detects a rise in a temperature of an electrically conductive section.
The energy meter disclosed in Patent Literature 1 is configured to include a temperature detecting section provided in the vicinity of the electrically conductive section and of terminal parts in the energy meter so that in a case where it is determined that temperature-related data outputted from the temperature detecting section has a certain value or more, the energy meter displays or communicates that the temperature is at a certain value or more.
This allows an administrator to recognize, through the displaying or the transmission by the energy meter, that the energy meter has reached an abnormal temperature as a result of a consumer using an electric current so as to exceed a rated electric current. Therefore, the administrator is supposedly able to find out the cause of an abnormal temperature rise before the energy meter breaks, so that it is possible to prevent (i) breakage of the energy meter and (ii) damage to an electronic device and a house, which damage results from the breakage of the energy meter.

Citation List

[Patent Literature]

[Patent Literature 1] Japanese Patent Application Publication, *Tokukai,* No. 2010-19680 (Publication Date: January 28, 2010)

Summary of Invention

Technical Problem

With the energy meter disclosed in Patent Literature 1, it is possible to expect, by use of a temperature which has propagated through a power supply side or a load side, a temperature rise which will lead to the breakage of the energy meter.
In reality, however, fraudulent activities of willfully burning an energy meter have been committed. Against such fraudulent activities, therefore, it is important to identify that the energy meter has been burned from outside the energy meter. However, the conventional energy meter disclosed in Patent Literature 1 unfortunately does not make it possible to determine whether fire has broken out from inside the energy meter or the fire has been set to the energy meter from outside.
The present invention has been made in view of the conventional problem, and it is an object of the present invention to provide an energy meter and an energy meter fire outbreak location identification method, each of which can (i) determine whether a temperature rise of an energy meter main body results from a fire outbreak from outside or a fire outbreak from inside and (ii) retain the result of the determination.

Solution to Problem

In order to solve the above problem, an energy meter in accordance with an aspect of the present invention is an energy meter for accumulating power consumption, including: a temperature detecting section configured to detect a rise in an internal temperature of an energy meter main body; a determining section configured to determine, on a basis of a rate of the rise in the internal temperature, whether the rise in the internal temperature results from a fire outbreak from outside the energy meter main body or a fire outbreak from inside the energy meter main body; and a transmitting section configured to transmit a result of the determination made by the determining section to an outside entity.

In order to solve the above problem, an energy meter fire outbreak location identification method in accordance with an aspect of the present invention is an energy meter fire outbreak location identification method for identifying a location of a fire outbreak on an energy meter for accumulating power consumption, including: a temperature detecting step of detecting a rise in an internal temperature of an energy meter main body; a determining step of determining, on a basis of a rate of the rise in the internal temperature, whether the rise in the internal temperature results from a fire outbreak from outside the energy meter main body or a fire outbreak from inside the energy meter main body; and a transmitting step of transmitting a result of the determination made in the determining step to an outside entity.

Advantageous Effects of Invention

With an aspect of the present invention, it is advantageously possible to provide an energy meter and an energy meter fire outbreak location identification method, each of which can (i) determine whether a temperature rise of an energy meter main body results from a fire outbreak from outside the energy meter main body or a fire outbreak from inside the energy meter main body and (ii) retain the result of the determination.

Brief Description of Drawings

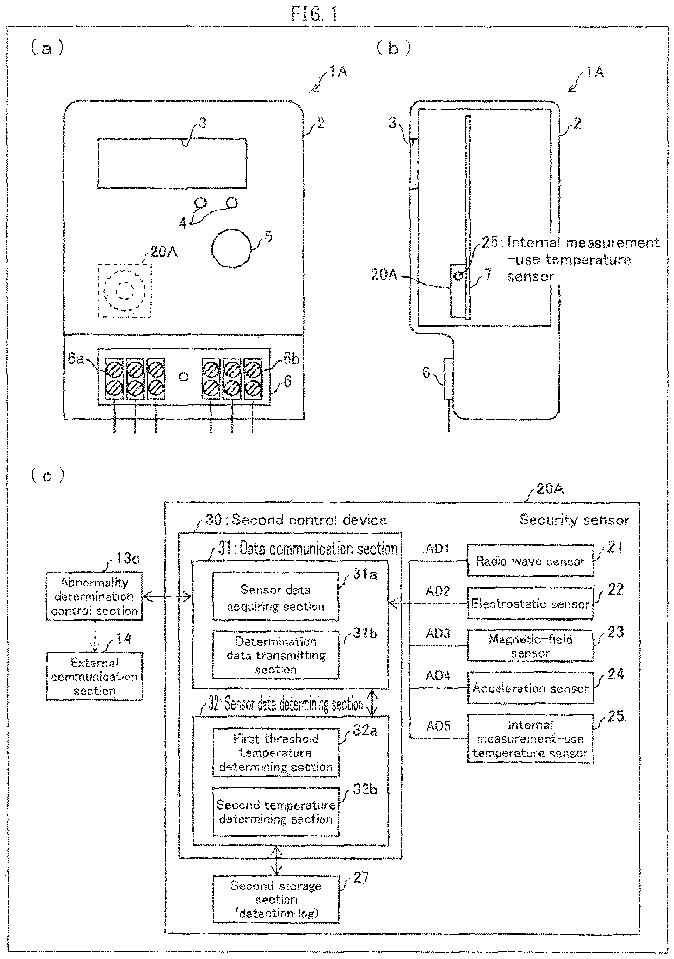

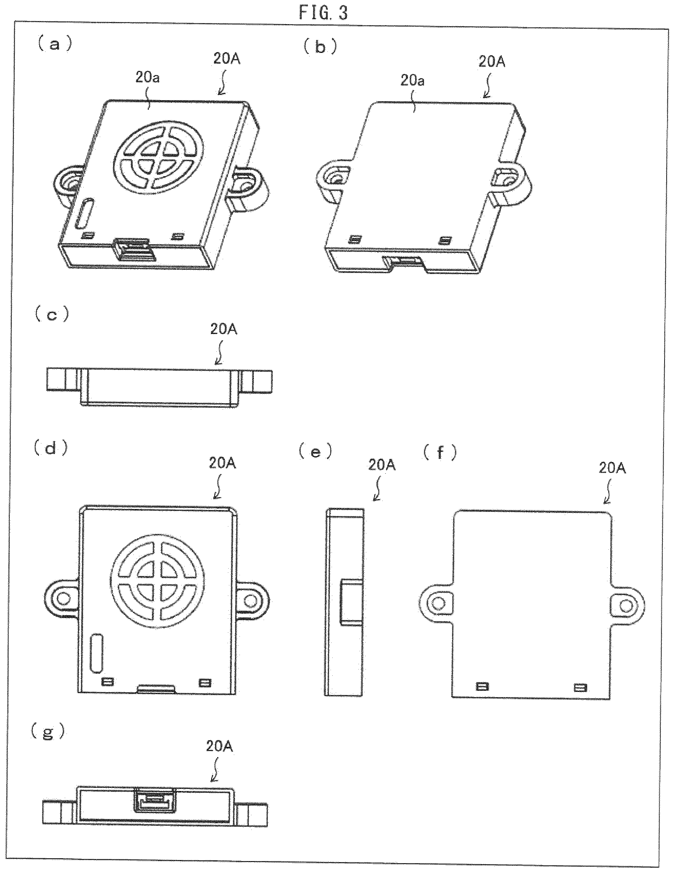

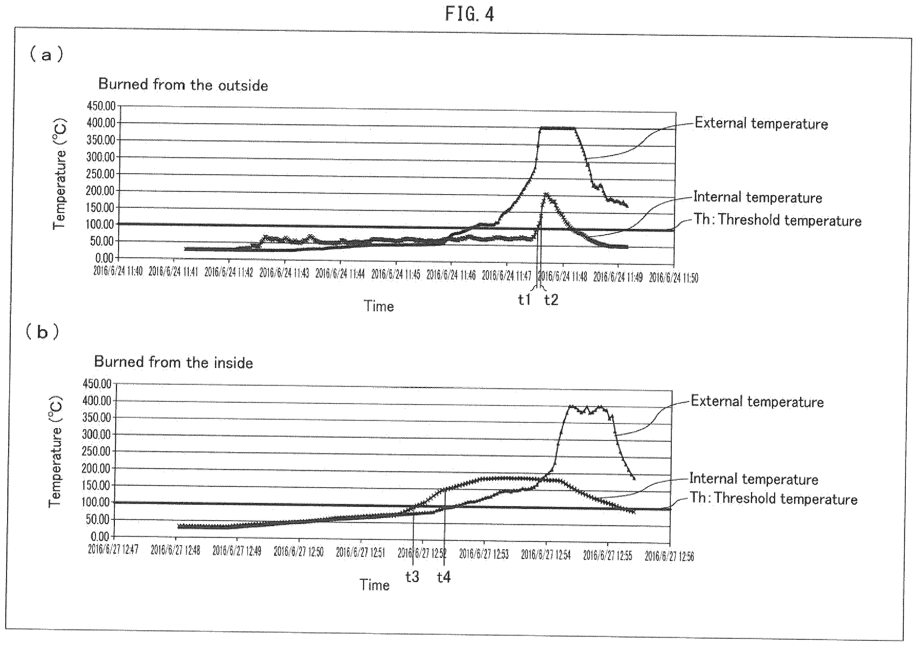

(a) of Fig. 1 is an elevational view illustrating an external configuration of an energy meter in accordance with Embodiment 1 of the present invention, (b) of Fig. 1 is a lateral cross-sectional view illustrating the configuration of the energy meter, and (c) of Fig. 1 is a block diagram illustrating the configuration of a security sensor of the energy meter.

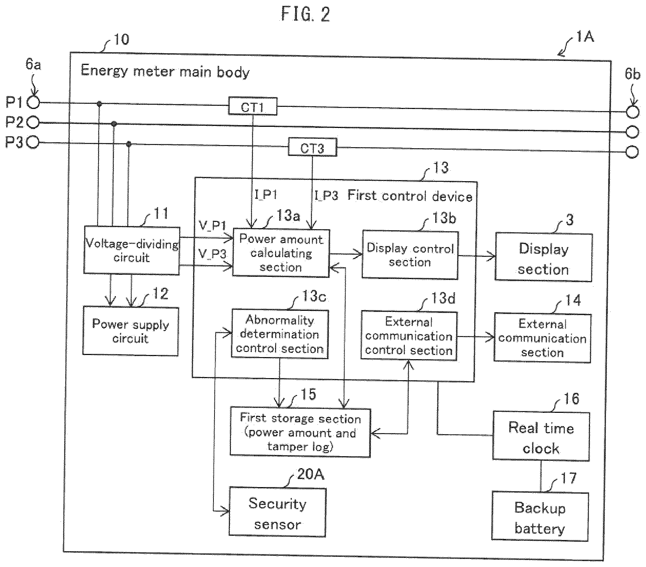

Fig. 2 is a block diagram illustrating an internal configuration of an energy meter main body of the energy meter.
(a) to (g) of Fig 3 are views illustrating the appearance of the security sensor.
(a) of Fig. 4 is a graph showing temperature changes in internal and external temperatures in a case where the energy meter has been burned from outside the energy meter, and (b) of Fig. 4 is a graph showing temperature changes in internal and external temperatures in a case where fire has broken out from inside the energy meter.
Fig. 5 is a flowchart showing a flow of a process for determining, with use of an internal measurement-use temperature sensor, whether a temperature rise of the energy meter main body results from a fire outbreak from outside or a fire outbreak from inside.
Fig. 6 is a diagram schematically illustrating a method of calculating a temperature gradient of the energy meter main body in a case where the internal measurement-use temperature sensor is used.
Fig. 7 is a block diagram illustrating a configuration of a security sensor of an energy meter in accordance with Embodiment 2 of the present invention.
Fig. 8 is a flowchart showing a flow of a process for determining, with use of a first threshold-use thermal fuse and a second threshold-use thermal fuse, whether a temperature rise of the energy meter main body results from a fire outbreak from outside the energy meter main body or a fire outbreak from inside the energy meter main body.
Fig. 9 is a diagram schematically illustrating a method of calculating a temperature gradient of the energy meter main body in a case where the first threshold-use thermal fuse and the second threshold-use thermal fuse are used.

Description of Embodiments

[Embodiment 1]

The following will describe an embodiment of the present invention with reference to Figs. 1 to 6.
An energy meter in accordance with Embodiment 1, which is a so-called smart meter, is a next-generation energy meter that digitally measures electric power and includes a communication capability inside the meter, unlike the conventional analog induction type energy meter. Specifically, the conventional energy meter, for example, measures the total amount of one-month power consumption by monthly meter reading, whereas the smart meter, for example, transmits the amount of power consumption to an administrator every 30 minutes on a daily basis. Thus, the smart meter has the advantage of eliminating the need for a meter reader to perform a meter reading work.

[Configuration of energy meter]

(a) of Fig. 1 is an elevational view illustrating an external configuration of the energy meter 1A in accordance with Embodiment 1, and (b) of Fig. 1 is a lateral cross-sectional view illustrating the configuration of the energy meter 1A.

As illustrated in (a) and (b) of Fig. 1, the energy meter 1A in accordance with Embodiment 1 includes a housing 2 which has, for example, a substantially rectangular shape and is made out of, for example, a resin product. The housing 2 has a display section 3, two light emitting diode (LED) lamps 4, and a data extraction terminal 5 provided in an upper part on the front side thereof, and also has a terminal board 6 provided in a lower part on the front side thereof. Inside the housing 2, an internal measurement-use temperature sensor 25 is housed in a security sensor 20A which is fixed on a circuit board 7. The internal measurement temperature sensor 25 serves as a first temperature detecting section, a second temperature detecting section, and an internal temperature measuring section.

The display section 3 is realized by a liquid crystal display (LCD) device and is configured to display the amount of power consumption.

One of the LED lamps 4 illuminates during operation of the energy meter 1A to indicate that the energy meter 1A is in operation. Another one of the LED lamps 4 is a lamp which flashes quickly as the amount of power consumption increases to indicate a rate at which the amount of power consumption increases.

In Embodiment 1, the terminal board 6 is provided with, for example, three input terminals 6a and three output terminals 6b. The input terminals 6a are connected to, for example, transmission lines from a utility pole outside a building. On the other hand, the output terminals 6b are connected to wiring lines to the inside of a building. In Embodiment 1, the terminal board 6 is a terminal board in a three-phase AC system. However, the terminal board 6 is not necessarily limited to such a terminal board. Alternatively, the terminal board 6 may be a terminal board in a two-phase AC system.

Fig. 2 is a block diagram illustrating an internal configuration of an energy meter main body 10 of the energy meter 1A. As illustrated in Fig. 2, the energy meter 1A in accordance with Embodiment 1 digitally measures the amount of electric power supplied to, for example, a home or the like through transmission lines P1 to P3 in a three-phase AC system.

The energy meter main body 10 of the energy meter 1A includes current sensors (current transformers) CT1 and CT3, a voltage-dividing circuit 11, a power supply circuit 12, a first control device 13, a display section 3, an external communication section 14 serving as a transmitting section, a first storage section 15, a real time clock (RTC) 16, a backup battery 17, and a security sensor 20A.

The current sensor CT1 detects a current value I_P1 in the transmission line PI, and the current sensor CT3 detects a current value I_P3 in the transmission line P3.

The voltage-dividing circuit 11 detects a voltage value V_P1 in the transmission line P1 and a voltage value V_P3 in the transmission line P3, and transmits data of the voltage value V_P1 and voltage value V_P3 to a power amount calculating section 13a of the first control device 13 (described later).

The power supply circuit 12 supplies electric power to hardware included in the energy meter 1A.

The display section 3 is a display device which is electrically connected directly to the first control device 13 and is controlled by the first control device 13 to output and display power consumption. The display section 3 is attached to the housing 2 so as to be visible from outside the energy meter 1A. This allows a consumer to view the information displayed on the display section 3.

The external communication section 14 serves as a communication port for communicating with a terminal device at an electric power company through a communication network (not illustrated). The communication network may be a radio communication network (for example, wireless LAN) or may be a wired communication network such as, for example, power line communication (PLC).

The first storage section 15 serves as a storage area for storing information, and employs, for example, an electrically erasable programmable read-only memory (EEPROM) (Registered Trademark) in Embodiment 1. The first storage section 15 stores the amount of power calculated by the power amount calculating section 13a (described later) and a tamper log determined by an abnormality determination control section 13c. The first control device 13 performs reading/writing of information from/to the first storage section 15.

The first control device 13 is constituted by a control circuit board for controlling the hardware in the energy meter 1A, specifically including a processor (for example, a central processing unit (CPU)) for executing a program.

The first control device 13 includes the power amount calculating section 13a, a display control section 13b, the abnormality determination control section 13c which serves as the determining section, and an external communication control section 13d. Although the first control device 13 is constituted by hardware, the power amount calculating section 13a, the display control section 13b, the abnormality determination control section 13c, and the external communication control section 13d, which are included in the first control device 13, are each a functional block representing the software functions executed by the first control device 13.

The power amount calculating section 13a represents a function block for calculating (measuring) the amount of electric power supplied to a house through the transmission lines P1 to P3 (i.e., the power consumption of a power supply target) using detection values from the current sensors CT1 and CT3 and the voltage-dividing circuit 11.

Specifically, the power amount calculating section 13a calculates an instantaneous power value in the transmission line P1 by multiplying the current value IP_1 by the voltage value V_P1 and calculates an instantaneous power value in the transmission line P3 by multiplying the current value I_P3 by the voltage value V_P3. Then, the power amount calculating section 13a calculates a first power consumption for a first prescribed period (for example, a few seconds) by time-integrating the sum of the instantaneous power value in the transmission line P1 and the instantaneous power value in the transmission line P3.

Further, the power amount calculating section 13a calculates a second power consumption for every second prescribed period (15 minutes in Embodiment 1) which is longer than the first prescribed period, and stores the second power consumption in the first storage section 15.

Note that the power amount calculating section 13a does not necessarily calculate the first power consumption for every few seconds or the second power consumption for every 15 minutes. For example, the power amount calculating section 13a may calculate the power consumption for every day or for every month and store the calculated power consumption in the first storage section 15.

The display control section 13b represents a block for controlling the display section 3. The display control section 13b acquires the first power consumption from the power amount calculating section 13a every time the power amount calculating section 13a calculates, for example, the first power consumption, and causes the first power consumption to be displayed on the display section 3.

Further, the display control section 13b may cause any one of the second power consumption for 15 minutes, daily power, and monthly power stored in the first storage section 15 to be displayed on the display section 3 in response to the input of an external command (a command from an operator).

The abnormality determination control section 13c acquires a tamper log (detailed later) generated by the security sensor 20A from the security sensor 20A and stores the tamper log in the first storage section 15. Specifically, every time a first threshold temperature determining section 32a and a second temperature determining section 32b of a sensor data determining section 32 in the security sensor 20A determine temperatures, determination results are transmitted via a determination data transmitting section 31b to the abnormality determination control section 13c. The abnormality determination control section 13c determines whether a temperature rise in an internal temperature results from a fire outbreak from outside the energy meter main body 10 or a fire outbreak from inside the energy meter main body 10, on the basis of the determination results obtained by the first threshold temperature determining section 32a and the second temperature determining section 32b. Then, in a case where the abnormality determination control section 13c determines that a temperature rise of an internal temperature results from a fire outbreak from outside the energy meter main body 10, such a fact which serves as an evidence that a person who performs fraudulent activity burned the energy meter 1A is stored as a tamper log in the first storage section 15.

Every time the power amount calculating section 13a calculates power consumption, the external communication control section 13d controls the external communication section 14 to transmit power amount information indicating power consumption to a terminal device (not illustrated) of the electric power company which is an administrator.

Further, the external communication control section 13d transmits the tamper log having been determined by the abnormality determination control section 13c and stored in the first storage section 15, via the external communication section 14 to the terminal device of the electric power company which is the administrator.

The real time clock (RTC) 16 outputs time information indicating the present time including the year, month, day, hour, minute, and second. Since the real time clock (RTC) 16 is connected to a backup battery 17, the RTC 16 will not stop operating because of a power outage or the like, and constantly outputs the exact time information.

Since the time information provided from the real time clock (RTC) 16 is transmitted to the first control device 13, the first control device 13 recognizes the present time on the basis of the time information provided from the real time clock (RTC) 16. A second control device 30 in the security sensor 20A (described later) also acquires time information from the real time clock (RTC) 16 through the first control device 13 when the security sensor 20A starts; sets a timer (not illustrated) to the present time acquired; and recognizes the present time on the basis of the timer.

(c) of Fig. 1 is a block diagram illustrating the configuration of the security sensor 20A of the energy meter 1A. (a) of Fig. 3 is a perspective view illustrating the security sensor 20A of the energy meter 1A when viewed from a front side of the security sensor 20A. (b) of Fig. 3 is a perspective view illustrating the security sensor 20 when viewed from a back side of the security sensor 20A. (c) to (g) of Fig. 3 are basic five views illustrating the appearance of the security sensor 20. Specifically, (c) of Fig. 3 is a plan view of the security sensor 20A, (d) of Fig. 3 is an elevational view of the security sensor 20A, (e) of Fig. 3 is a right side view of the security sensor 20A, (f) of Fig. 3 is a back side view of the security sensor 20A, and (g) of Fig. 3 is a bottom view of the security sensor 20A.

The security sensor 20A is a detection device installed on the circuit board 7 inside the housing 2, as illustrated in (a) and (b) of Fig. 1, and can be removed from the energy meter 1A. The security sensor 20A is configured to detect fraudulent activity carried out for electricity theft on the energy meter 1A.

As illustrated in (c) of Fig. 1, the security sensor 20A includes a radio wave sensor 21, an electrostatic sensor 22, a magnetic-field sensor 23, an acceleration sensor 24, an internal measurement-use temperature sensor 25, a second control device 30, and a second storage section 27. In this way, the energy meter 1A in Embodiment 1 is provided with various kinds of sensors for preventing electricity theft through a variety of fraudulent activities carried out on the energy meter 1A. However, in an aspect of the present invention, the security sensor 20A need only include at least the internal measurement-use temperature sensor 25.

The security sensor 20A has a resin package 20a illustrated in (a) and (b) of Fig. 3, which accommodates the radio wave sensor 21, the electrostatic sensor (ESD Surgesensor) 22, the magnetic-field sensor 23, the acceleration sensor 24, and the internal measurement-use temperature sensor 25.

The radio wave sensor 21 outputs a sensor value AD1 correlated with the amount of radio waves in a frequency band that would cause electromagnetic interference (EMI) in an electronic device. Specifically, when radio waves are emitted to render the processor for measuring power consumption (first control device 13 in Embodiment 1) inoperable, the sensor value AD1 outputted from the radio wave sensor 21 increases. Consequently, by detecting electromagnetic interference with use of the radio wave sensor 21, it is possible to prevent electricity theft committed through electromagnetic interference. When the first control device 13 is rendered inoperable by the emission of radio waves, the first control device 13 cannot measure power consumption, thereby allowing electricity theft to take place.

The electrostatic sensor (ESD surge sensor) 22 outputs a sensor value AD2 corresponding to an increased amount of charge when surge takes place in the energy meter 1A. Specifically, when an electrostatic discharge is induced to render the processor for measuring power consumption (first control device 13 in Embodiment 1) inoperable, surge takes place in the energy meter 1A, thus causing the sensor value AD2 to increase. Consequently, by detecting electrostatic discharge induced for the purpose of electricity theft with use of the electrostatic sensor 22, it is possible to prevent electricity theft committed through electrostatic discharge. When the first control device 13 is rendered inoperable by the electrostatic discharge, the first control device 13 cannot measure power consumption, thereby allowing electricity theft to take place.

The magnetic-field sensor 23 outputs a sensor value AD3 correlated with the intensity of a magnetic field. Specifically, when the energy meter 1A is exposed to a magnetic field for the purpose of causing the current sensors CT1 and CT3 to malfunction, the sensor value AD3 outputted from the magnetic-field sensor 23 increases. Consequently, by detecting exposure to a magnetic field with use of the magnetic-field sensor 23, it is possible to prevent electricity theft committed via exposure to a magnetic field. When the current sensors CT1 and CT3 malfunction due to exposure to a magnetic field, the current amount is not outputted normally, and thus the power amount calculating section 13a cannot measure the power amount, thereby allowing electricity theft to take place.

The acceleration sensor 24 measures a rate at which an object moves, and can detect inclination (gravity), motion, vibration and impact of an object. Specifically, when a fraudulent activity such as an impact given to the energy meter 1A with, for example, a drill is committed for the purpose of breaking the housing 2 of the energy meter 1A, the sensor value AD4 outputted from the acceleration sensor 24 increases. Consequently, by detecting breakage of the energy meter main body 10 committed for the purpose of electricity theft with use of the acceleration sensor 24, it is possible to prevent electricity theft committed via breakage of the energy meter main body 10. When the energy meter main body 10 is broken, the power amount cannot be measured. This allows electricity theft to take place.

The internal measurement-use temperature sensor 25 measures internal temperature of the energy meter main body 10, and includes, for example, a thermocouple or a resistance temperature detector. As described earlier, the internal measurement-use temperature sensor 25 in accordance with Embodiment 1 is housed inside the package 20a of the security sensor 20A, and measures internal temperature of the housing 2, internal temperature of the security sensor 20A in particular. Note that the internal measurement-use temperature sensor 25 does not necessarily need to be housed inside the package 20a of the security sensor 20A. Alternatively, the internal measurement-use temperature sensor 25 may be, for example, exposed and fixed on the circuit board 7, rather than being housed inside the package 20a, so that a temperature of the circuit board 7 or a temperature in the vicinity of the circuit board 7 is measured. There is a high possibility that the origin of a fire from inside is the power supply circuit 12 on the circuit board 7. Thus, it is preferable to provide the internal measurement-use temperature sensor 25 in the vicinity of the power supply circuit 12. The internal measurement-use temperature sensor 25 is preferably arranged apart from the housing 2.

The following will detail advantageous effects produced by the internal measurement-use temperature sensor 25, second control device 30, and second storage section 27.

[Configuration for preventing fraudulent activity of burning energy meter for the purpose of electricity theft]

Conventionally, a fraudulent activity of willfully burning an energy meter to destroy the display section on which an accumulated power consumption is displayed and accumulated power consumption data stored in the energy meter is committed for the purpose of electricity theft. In this case, when an administrator of, for example, an electric power company which administers the energy meter, files a claim for the damage against the wrongdoer, the wrongdoer may evade compensation for the damage by arguing that a fire broke out from inside the energy meter due to current leakage or the like.

Thus, against the fraudulent activity of willfully burning an energy meter, it is important to identify that the energy meter has been burned from outside the energy meter.

Here, temperature changes in internal temperature of an energy meter in the case where the energy meter has been burned from outside the energy meter and in the case where fire has broken out from inside the energy meter will be described on the basis of experimental results shown in (a) and (b) of Fig. 4. (a) of Fig. 4 is a graph showing temperature changes in internal and external temperatures in the case where the energy meter has been burned from outside the energy meter. (b) of Fig. 4 is a graph showing temperature changes in internal and external temperatures in the case where a fire has broken out from inside the energy meter. In (a) and (b) of Fig. 4, a vertical axis represents a temperature (°C), and a horizontal axis represents an elapsed time (year, month, day, hour, minute). In (a) of Fig. 4, fire is set from outside at 11:42:30. The external temperature is shown for reference and is a temperature of a vicinity of the housing 2 inside the housing 2 (a temperature of a place relatively close to the outside).

As shown in (a) of Fig. 4, in a case where the energy meter 1A has been burned from outside, the external temperature of the energy meter main body 10 rises earlier than the internal temperature of the energy meter main body 10, and after that, the internal temperature sharply rises at a given point in time. This is considered to occur because the housing 2 of the energy meter main body 10 is burned out at the point in time when the circuit board 7 and other members provided inside the energy meter main body 10 catch fire, and air is sufficiently distributed throughout the inside so that the inside of the energy meter main body 10 is burned within a short period in time.

Here, when an attention is focused on the internal temperature, the internal temperature detected by the internal measurement-use temperature sensor 25 is a threshold temperature Th (e.g., 100°C) preset at time t1 (11:47:30) and is 150°C at time t2 (11:47:40). In Embodiment 1, the threshold temperature Th is, for example, 100°C. However, the threshold temperature Th is not necessarily 100°C and may be other temperature.

Thus, a temperature gradient k, which is a temperature change per unit time (rate of rise of temperature), is expressed by:

$$\text{Temperature gradient k} = (150°C - 100°C) / (40 \text{ seconds} - 30 \text{ seconds})$$

$$= 50°C / 10 \text{ seconds}$$

$$= 5°C / \text{second}.$$

Meanwhile, as illustrated in (b) of Fig. 4, in a case where fire has broken out from inside the energy meter 1A, the internal temperature is less likely to rise sharply since the energy meter main body 10 is sealed and the inside of the energy meter 1A is deficient in oxygen. Finally, at a stage where burning of the housing 2 of the energy meter main body 10 leaves a hole, air (oxygen) is supplied through the hole, so that the external temperature of the energy meter 1A rises sharply.

Here, when an attention is focused on the internal temperature, the internal temperature detected by the internal measurement-use temperature sensor 25 is a threshold temperature Th (e.g., 100°C) preset at time t3 (12:51:50) and is 150°C at time t4 (12:52:15). In Embodiment 1, the threshold temperature Th is, for example, 100°C. However, the threshold temperature Th is not necessarily 100°C and may be other temperature.

Thus, a temperature gradient k, which is a temperature change per unit time, is expressed by:

$$\text{Temperature gradient } k = (150°C - 100°C) / (52$$

$$\text{minutes, 15 seconds - 51 minutes, 50 seconds})$$

$$= 50°C / 25 \text{ seconds}$$

$$= 2°C / \text{second.}$$

This result shows that while the internal temperature of the energy meter 1A exceeds the threshold temperature Th (i.e., while the inside of the housing 2 is burning), the temperature gradient based on a rise in the internal temperature of the energy meter 1A in the case where fire has broken out from outside the energy meter 1A is greater than the temperature gradient based on a rise in the internal temperature of the energy meter 1A in the case where fire has broken out from inside the energy meter 1A.

Thus, in the event of an outbreak of fire on the energy meter 1A, if it is possible to demonstrate that a temperature gradient calculated from the internal temperature of the energy meter 1A is greater than a preset threshold temperature gradient, it is evident that the fire broke out from outside the energy meter 1A, and it is thus possible to prove that the fraudulent activity of willfully burning the energy meter 1A was committed.

In view of this, the energy meter 1A in accordance with Embodiment 1 includes: the internal measurement-use temperature sensor 25 which serves as a temperature detecting section configured to detect a rise in the internal temperature of the energy meter main body 10; the abnormality determination control section 13c which serves as a determining section configured to determine, on the basis of a rate of rise in the internal temperature, whether the rise in the internal temperature results from a fire outbreak from outside the energy meter main body 10 or a fire outbreak from inside the energy meter main body 10; and the external communication section 14 which serves as a transmitting section configured to transmit a result of the determination made by the abnormality determination control section 13c to an outside entity.

Specifically, the second control device 30, which is configured to perform control so that the above operations are performed, includes a data communication section 31 and the sensor data determining section 32. The second control device 30 is constituted by a control circuit board separated from the first control device 13, including a processor (for example, a CPU) for controlling the hardware in the security sensor 20A.

The data communication section 31 includes a sensor data acquiring section 31a and a determination data transmitting section 31b which serves as a determination result transmitting section. The sensor data acquiring section 31a acquires data AD5, transmitted from the internal measurement-use temperature sensor 25, on the internal temperature of the energy meter main body 10 or acquires sensor values AD1 to AD4 transmitted from the other sensors 21 to 24, respectively. When it is determined that a temperature detected by the internal measurement-use temperature sensor 25 has reached the first threshold temperature and the second temperature, the determination data transmitting section 31b transmits that information to the abnormality determination control section 13c.

Next, the sensor data determining section 32 includes the first threshold temperature determining section 32a and the second temperature determining section 32b.

The first threshold temperature determining section 32a compares the data AD5, transmitted from the internal measurement-use temperature sensor 25, on the internal temperature of the energy meter main body 10 to the preset threshold temperature Th. Then, when the data AD5 on the internal temperature of the energy meter main body 10 has become equal to or higher than the threshold temperature Th which serves as a first threshold temperature, the first threshold temperature determining section 32a immediately transmits (i) information indicative of the fact that the data AD5 on the internal temperature of the energy meter main body 10 becomes equal to or higher than the threshold temperature Th and (ii) a detection time at which the internal temperature has been detected to the abnormality determination control section 13c via the determination data transmitting section 31b.

The second temperature determining section 32b compares the data AD5, periodically transmitted from the internal measurement-use temperature sensor 25, on the internal temperature of the energy meter main body 10 to the preset threshold temperature Th which serves as the first threshold temperature. Then, the second temperature determining section 32b determines whether a second temperature T2, which is a current internal temperature, is higher than a first temperature T1, which is a temperature equal to or higher than the threshold temperature Th. Further, the second temperature determining section 32b immediately transmits (i) result of the determination and (ii) a detection time at which the internal temperature used for the determination has been detected to the abnormality determination control section 13c via the determination data transmitting section 31b.

Note that the threshold temperature Th can be changed via the external communication section 14 by an entry through a terminal device (not illustrated) of the administrator.

Here, the sensor data determining section 32 is connected to the second storage section 27. The second storage section 27 stores, as a detection log, a status of the determinations performed by the first threshold temperature determining section 32a and the second temperature determining section 32b in the sensor data determining section 32.

The second storage section 27 includes a storage area for storing information and employs a flash memory in Embodiment 1. The second control device 30 performs reading/writing of information from/to the second storage section 27.

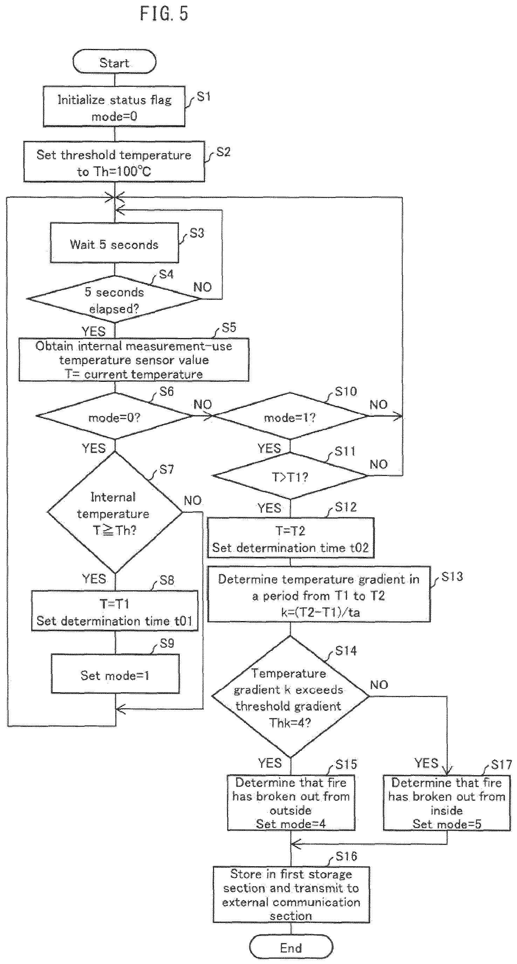

Fig. 5 is a flowchart showing a flow of a process for determining, with use of the internal measurement-use temperature sensor 25, whether a temperature rise of the energy meter main body 10 results from a fire outbreak from outside the energy meter main body 10 or a fire outbreak from inside the energy meter main body 10.

As illustrated in Fig. 5, first, a status flag is initialized (S1). Specifically, "mode=0" is set as an initial value. Next, the threshold temperature Th is set (S2). According to Embodiment 1, the threshold temperature Th is set to, for example, 100°C. Note that the threshold temperature Th is preferably set to a temperature which is, for example, (i) not lower than 80°C above which the internal temperature becomes high within a short period in time as illustrated in (a) of Fig. 4 and (ii) not higher than 170°C that is equal to or below a maximum temperature of the internal temperature illustrated in (b) of Fig. 4. In addition, the threshold temperature Th needs to be higher than an ordinary living temperature. If the threshold temperature Th is set to an excessively high temperature, then there is a risk that a circuit board 7 or the like may be burned to the point of breakage, so as not to be able to transmit data to be transmitted. In Embodiment 1, therefore, the threshold temperature Th is, for example, 100°C.

Next, the process waits (on standby) 5 seconds (S3), and then determines whether or not 5 seconds has elapsed (S4). In a case where it is determined in the step S4 that 5 seconds has not elapsed, the process returns to the step S3. Although the standby time is, for example, 5 seconds in Embodiment 1, the standby time is not necessarily limited to 5 seconds, and can be set to another value. Note, however, that as illustrated in (a) and (b) of Fig. 4, the external temperature and the internal temperature each change rapidly after the energy meter main body 10 starts burning. In a case where, for example, fire has broken out from inside as illustrated in (b) of Fig. 4, the following is true: t4 - t3 = 35 sec. Therefore, the standby time is preferably 15 seconds or less, more preferably 10 seconds or less, and most preferably 5 seconds or less.

In a case where it is determined in the step S4 that 5 seconds has elapsed, a current internal temperature T is obtained as data AD5 on the external temperature measured by the internal measurement-use temperature sensor 25 (S5).

Next, it is determined whether or not the "mode=0" is true (S6).

In a case where it is determined in the step S6 that "mode=0" is true, it is then determined whether or not "internal temperature $T \geq$ threshold temperature Th" is true (S7). In a case where it is determined in the step S7 that "internal temperature $T \geq$ threshold temperature Th" is true, (i) the internal temperature T at that time is set as the first temperature T1 and (ii) a determination time at which the determination in the step S7 has been made is set to t01 (S8). Then, "mode=1" is set (S9), and the process returns to the step S3. Meanwhile, in a case where it is determined in the step S7 that "internal temperature $T \geq$ threshold temperature Th" is false, the process directly returns to the step S3.

Meanwhile, in a case where it is determined in the step S6 that "mode=0" is false, it is then determined whether or not "mode=1" is true (S10).

In a case where it is determined in the step S10 that "mode=1" is true, it is then determined whether or not "internal temperature T > first temperature T1" is true (S11). In a case where it is determined in the step S11 that "internal temperature T > first temperature T1" is true, (i) the internal temperature T at that time is set as the second temperature T2 and (ii) a determination time at which the determination in the step S11 has been made is set to t02 (S12).

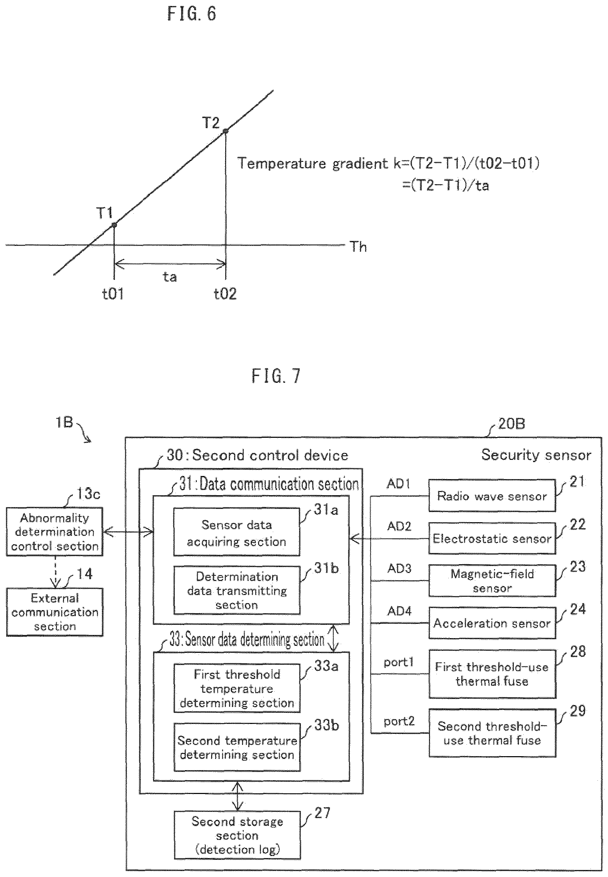

Then, on the basis of the fact that there has been a change from the first temperature T1 at the determination time t01 to the second temperature T2 at the determination time t02, a temperature gradient k per unit time (rate of rise in temperature) is calculated (S13). As illustrated in Fig. 6, the temperature gradient k can be determined by:

$$\text{Temperature gradient k} = (T2 - T1) / (t02 - t01)$$

$$= (T2 - T1) / ta.$$

Then, it is determined whether the temperature gradient k exceeds a threshold gradient Thk (S14). In Embodiment 1, the threshold gradient Thk is assumed to be, for example, threshold gradient Thk = 4 (°C/sec). This is because, as illustrated in (a) and (b) of Fig. 4, the temperature gradient of the internal temperature in the case where fire has broken out from outside the energy meter main body 10 is 5 (°C/sec), and the temperature gradient of the internal temperature in the case where fire has broken out from inside the energy meter main body 10 is 2 (°C/sec). Note that the temperature gradient of the internal temperature illustrated in (a) and (b) of Fig. 4 is an example temperature gradient. Therefore, the threshold gradient Thk = 4 (°C/sec) is an example threshold gradient. Alternatively, another value can be employed as the threshold gradient Thk.

Then, in a case where it is determined in the step S14 that the temperature gradient k exceeds the threshold gradient Thk, (i) it is then determined that fire has been set from outside and (ii) "mode=4" is set (S15). Then, the result of the determination is stored as a tamper log in the first storage section 15, and then the result of the determination is transmitted to the external communication section 14 (S16). The external communication section 14 transmits the result of the determination to a terminal device provided outside the energy meter. Note that it is the abnormality determination control section 13c which (i) determines whether the temperature gradient k exceeds the threshold gradient Thk and (ii) determines that fire has been set from outside.

Meanwhile, in a case where it is determined in the step S14 that the temperature gradient k does not exceed the threshold temperature Thk, (i) it is then determined that fire has broken out from inside and (ii) "mode=5" is set (S17). Then, the result of the determination is stored in the first storage section 15, and then is transmitted to the external communication section 14 (S16). The external communication section 14 transmits the result of the determination to a terminal device provided outside the energy meter. Note that it is the abnormality determination control section 13c which (i) determines whether the temperature gradient k exceeds the threshold gradient Thk and (ii) determines that fire has broken out from inside.

Note that in a case where it is determined in the step S10 that "mode=0" is false, and in a case where it is determined in the step S11 that "internal temperature T > first temperature T1" is false, the process returns to the step S3.

As described above, the energy meter 1A, in accordance with Embodiment 1, for accumulating power consumption includes: the temperature detecting section configured to detect a rise in the internal temperature of the energy meter main body 10; the abnormality determination control section 13c which serves as a determining section configured to determine, on the basis of a rate of the rise in the internal temperature, whether the rise in the internal temperature results from a fire outbreak from outside the energy meter main body 10 or a fire outbreak from inside the energy meter main body 10; and the external communication section 14 which serves as a transmitting section configured to transmit a result of the determination made by the abnormality determination control section 13c to an outside entity.

Further, the energy meter 1A, in accordance with Embodiment 1, for accumulating power consumption includes: a first temperature detecting section configured to detect that the internal temperature of the energy meter main body 10 has reached the preset first threshold temperature Th; a second temperature detecting section configured to detect that the internal temperature has reached the second temperature T2, which is higher than the first threshold temperature Th; the abnormality determination control section 13c which serves as a determining section configured to determine, on the basis of a result of the detection performed by the first temperature detecting section and a result of the detection performed by the second temperature detecting section, whether the temperature rise in the internal temperature results from a fire outbreak from outside the energy meter main body 10 or a fire outbreak from inside the energy meter main body 10; and the external communication section 14 which serves as a transmitting section configured to transmit a result of the determination made by the abnormality determination control section 13c to an outside entity.

Consequently, even if data on, for example, power consumption charge stored inside the energy meter main body 10 is deleted by the burning of the energy meter 1A, an administrator of the energy meter 1A obtains, through transmission, the result of the determination as to whether the temperature rise in the internal temperature results from a fire outbreak from outside the energy meter main body 10 or a fire outbreak from inside the energy meter main body 10, before the energy meter main body 10 is burned out.

Thus, it is possible to provide the energy meter 1A which can (i) determine whether a temperature rise of the energy meter main body 10 results from a fire outbreak from outside the energy meter main body 10 or a fire outbreak from inside the energy meter main body 10 and (ii) retain a result of the determination.

Note that the administrator of the energy meter 1A can file a claim for damages against a fraudster on the evidence of the result of the determination.

Further, according to the energy meter 1A in accordance with Embodiment 1, in a case where (i) the internal temperature is equal to or higher than the first threshold temperature and (ii) a rate of rise in the internal temperature (temperature gradient k) exceeds a threshold rate (threshold gradient Thk), the abnormality determination control section 13c determines that a rise in the internal temperature results from a fire outbreak from outside the energy meter main body 10.

Specifically, the first temperature detecting section includes: the internal measurement-use temperature sensor 25 which serves as an internal temperature measuring section configured to periodically measure the internal temperature; and the first threshold temperature determining section 32a configured to determine whether the internal temperature has reached the first temperature T1 which is equal to or higher than the first threshold temperature Th, and the second temperature detecting section includes the second temperature determining section 32b configured to determine whether the second temperature T2, which is obtained through periodical measurement with use of the internal measurement-use temperature sensor 25, is higher than the first temperature T1. The first temperature detecting section includes the determination data transmitting section 31b which serves as the determination result transmitting section configured to transmit (i) the results of the determinations made by the first threshold temperature determining section 32a and the second temperature determining section 32b and (ii) detection times at which the internal temperatures used for the determinations made by the first threshold temperature determining section 32a and the second temperature determining section 32b have been detected to the abnormality determination control section 13c which serves as the determining section. The abnormality determination control section 13c determines the temperature gradient k per unit time based on the amount of time elapsed from the first temperature T1 to the second temperature T2, and compares the temperature gradient k to the preset threshold gradient Thk to determine whether a temperature rise in the internal temperature results from a fire outbreak from outside the energy meter main body 10 or a fire outbreak from inside the energy meter main body 10.

In this way, the first temperature detecting section and the second temperature detecting section each periodically measure the internal temperature of the energy meter main body 10 with use of the internal measurement-use temperature sensor 25. This means that the internal measurement-use temperature sensor 25 should be constituted by, for example, a temperature sensor or the like. The internal measurement-use temperature sensor 25 constituted by a temperature sensor or the like quantitatively measures temperatures. Thus, the first threshold temperature determining section 32a determines whether the internal temperature has reached the first temperature T1 which is equal to or higher than the first threshold temperature Th, and the second temperature determining section 32b determines whether the second temperature T2, which is obtained through periodical measurement with use of the internal measurement-use temperature sensor 25, is higher than the first temperature T1.

Then, (i) the results of the determinations made by the first threshold temperature determining section 32a and the second temperature determining section 32b and (ii) the detection times are transmitted by the determination data transmitting section 31b to the abnormality determination control section 13c. Further, the abnormality determination control section 13c determines the temperature gradient k per unit time based on the amount of time elapsed from the first temperature T1 to the second temperature T2, and compares the temperature gradient k to the preset threshold gradient Thk to determine whether a temperature rise in the internal temperature results from a fire outbreak from outside the energy meter main body 10 or a fire outbreak from inside the energy meter main body 10.

Thus, in a case where the quantitative internal measurement-use temperature sensor 25 is used, specifically, the abnormality determination control section 13c can transmit, to an outside entity via the external communication section 14, the result of the determination as to whether a temperature rise in the internal temperature results from a fire outbreak from outside the energy meter main body 10 or a fire outbreak from inside the energy meter main body 10.

Further, according to the energy meter 1A in accordance with Embodiment 1, the temperature detecting section periodically measures the internal temperature, and the external communication section 14 which serves as a transmitting section transmits (i) a measured internal temperature and (ii) a measurement time at which the internal temperature has been measured to an outside entity.

Specifically, the determination data transmitting section 31b which serves as the determination result transmitting section transmits (i) the measured internal temperature and (ii) the detection time to the abnormality determination control section 13c which serves as the determining section, and then, (i) the measured internal temperature and (ii) the detection time, both of which have been transmitted to the abnormality determination control section 13c, are transmitted by the external communication section 14 which serves as the transmitting section to an outside entity.

With this arrangement, not only the result of the determination as to whether a temperature rise in the internal temperature results from a fire outbreak from outside the energy meter main body 10 or a fire outbreak from inside the energy meter main body 10, but also the measured internal temperature and the detection time are transmitted. Thus, the administrator can obtain specific information on change in internal temperature.

Meanwhile, in a case where an energy meter is burned, a rate of temperature rise per unit time is high. Thus, unless the internal temperature is detected frequently, it is impossible to determine an accurate temperature gradient.

In view of this, according to the energy meter 1A in accordance with Embodiment 1, the temperature detecting section (first temperature detecting section and second temperature detecting section) detects the internal temperature at intervals of 15 seconds or less.

This makes it possible to determine an accurate temperature gradient and makes it possible to accurately determine whether a temperature rise in the internal temperature results from a fire outbreak from outside the energy meter main body 10 or a fire outbreak from inside the energy meter main body 10.

Further, an energy meter fire outbreak location identification method in accordance with Embodiment 1 identifies whether a location of a fire outbreak on the energy meter 1A for accumulating power consumption is inside the energy meter 1A or outside the energy meter 1A. The above energy meter fire outbreak location identification method includes: a temperature detecting step of detecting a rise in the internal temperature of the energy meter main body 10; a determining step of determining, on the basis of a rate of the rise in the internal temperature, whether the rise in the internal temperature results from a fire outbreak from outside the energy meter main body 10 or a fire outbreak from inside the energy meter main body 10; and a transmitting step of transmitting a result of the determination made in the determining step to an outside entity.

Specifically, the above energy meter fire outbreak location identification method includes: a first temperature detecting step of detecting that the internal temperature of the energy meter main body 10 has reached the preset first threshold temperature Th1; a second temperature detecting step of detecting that the internal temperature has reached the second temperature T2, which is higher than the first threshold temperature; a determining step of determining, on the basis of results of the detections performed in the first temperature detecting step and in the second temperature detecting step, whether the temperature rise in the internal temperature results from a fire outbreak from outside the energy meter main body 10 or a fire outbreak from inside the energy meter main body 10; and a transmitting step of transmitting a result of the determination made in the determining step to an outside entity.

This makes it possible to provide the energy meter fire outbreak location identification method which can (i) determine whether a temperature rise of the energy meter main body 10 results from a fire outbreak from outside the energy meter main body 10 or a fire outbreak from inside the energy meter main body 10 and (ii) retain a result of the determination.

[Embodiment 2]

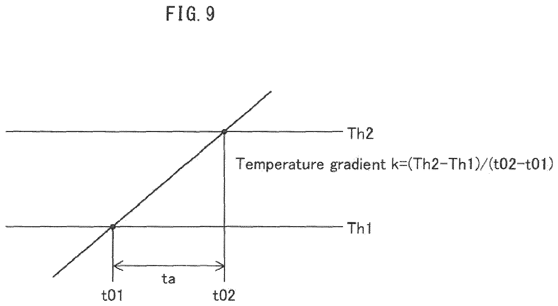

The following description will discuss another embodiment of the present invention with reference to Figs. 7 to 9. Features of Embodiment 2 other than those described in Embodiment 2 are identical to those of Embodiment 1. For convenience, members having functions identical to those illustrated in the drawings of Embodiment 1 are given identical reference signs, and their descriptions are omitted.

The energy meter 1A in accordance with Embodiment 1 includes the internal measurement-use temperature sensor 25 which serves as an internal temperature measuring section configured to periodically measure the internal temperature, and the energy meter 1A thus measures temperatures quantitatively.

Meanwhile, an energy meter 1B in accordance with Embodiment 2 differs in that (i) the energy meter 1B includes: a first threshold-use thermal fuse 28 which melts when the internal temperature of the energy meter main body 10 becomes equal to or higher than a first threshold temperature Th1; and a second threshold-use thermal fuse 29 which melts when the internal temperature of the energy meter main body 10 becomes equal to or higher than a second threshold temperature Th2, and (ii) the energy meter 1B thus measures the first threshold temperature Th1 and the second threshold temperature Th2 qualitatively.

Fig. 7 is a block diagram illustrating a configuration of a security sensor 20B of the energy meter 1B in accordance with Embodiment 2.

As illustrated in Fig. 7, the security sensor 20B of the energy meter 1B in accordance with Embodiment 2 differs in that the energy meter 1B is provided with a first threshold-use thermal fuse 28 and a second threshold-use thermal fuse 29 instead of the internal measurement-use temperature sensor 25 included in the security sensor 20A of the energy meter 1A in accordance with Embodiment 1.

The first threshold-use thermal fuse 28 is constituted by a circuit including a fuse which melts at a first threshold temperature Th1 set in advance. The second threshold-use thermal fuse 29 is constituted by a circuit including a fuse which melts at a second threshold temperature Th2 set in advance. For example, an electric current (not illustrated) flows through the first threshold-use thermal fuse 28 and the second threshold-use thermal fuse 29. The first threshold-use thermal fuse 28 and the second threshold-use thermal fuse 29 each melt when reaching a temperature equal to or higher than the first threshold temperature Th1 and the second threshold temperature Th2, respectively, so that the electric current becomes blocked. This makes it possible to detect that the first threshold-use thermal fuse 28 or the second threshold-use thermal fuse 29 has melted.

Whether or not the first threshold-use thermal fuse 28 has melted and whether or not the second threshold-use thermal fuse 29 has melted (i.e. whether or not an electric current which was flowing is blocked) can be determined by a first threshold temperature determining section 33a and a second threshold temperature determining section 33b, respectively, of a sensor data determining section 33.

The fact that the first threshold-use thermal fuse 28 has reached a temperature equal to or higher than the first threshold temperature Th1 so as to melt and the fact that the second threshold-use thermal fuse 29 has reached a temperature equal to or higher than the second threshold temperature Th2 so as to melt, both of which facts have been determined by the first threshold temperature determining section 33a and the second threshold temperature determining section 33b, respectively, are stored as a detection log in a second storage section 27 and are transmitted to an abnormality determination control section 13c via a determination data transmitting section 31b of a data communication section 31. Further, the abnormality determination control section 13c determines a temperature gradient k per unit time based on the amount of time elapsed from a time at which the first threshold temperature Th1 has been reached to a time at which the second threshold temperature Th2 has been reached, and compares the temperature gradient k to a preset threshold gradient Thk. The abnormality determination control section 13c performs the comparison to determine whether a temperature rise in the internal temperature results from a fire outbreak from outside the energy meter main body 10 or a fire outbreak from inside the energy meter main body 10. Then, a result of the determination is stored in a first storage section 15, and data thus stored (the result of the determination) is transmitted to a terminal device of an administrator via an external communication control section 13d and an external communication section 14. With the process above, an administrator can recognize, with use of an in-house terminal device (not illustrated), that fire has been set to the energy meter 1B from outside.

Note that in Embodiment 2, a relationship between the first threshold temperature Th1 and the second threshold temperature Th2 is expressed as "first threshold temperature Th1 < second threshold temperature Th2", and the first threshold temperature Th1 is, for example, 100°C, and the second threshold temperature Th2 is, for example, 150°C. However, the first threshold temperature Th1 and the second threshold temperature Th2 are not necessarily limited to these values, and can be any other values. Further, for each of the first threshold-use thermal fuse 28 and the second threshold-use thermal fuse 29, an element having a melting temperature corresponding to a desired first threshold temperature Th1 and an element having a melting temperature corresponding to a desired second threshold temperature Th2 can be selected as appropriate from various commercially-available elements corresponding to various melting temperatures.

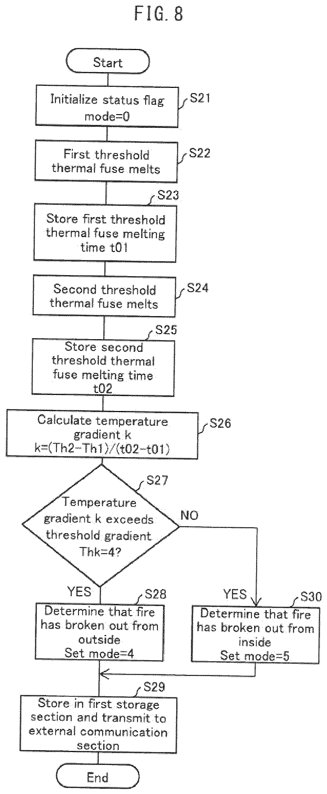

Fig. 8 is a flowchart showing a flow of a process for determining, with use of the first threshold-use thermal fuse 28 and the second threshold-use thermal fuse 29, whether a temperature rise of the energy meter main body 10 results from a fire outbreak from outside the energy meter main body 10 or a fire outbreak from inside the energy meter main body 10.

As illustrated in Fig. 8, first, a status flag is initialized (S21). Specifically, mode=0 is set as an initial value.

Assume that the first threshold-use thermal fuse 28 melted during standby in this state (S22). At this time, the first threshold temperature determining section 33a immediately determines that the first threshold-use thermal fuse 28 has melted, sets a determination time at which the determination has been made by the first threshold temperature determining section 33a to t01, and stores the determination time in the second storage section 27 (S23).

Then, after a while, the internal temperature of the energy meter main body 10 rises. This causes melting of the second threshold-use thermal fuse 29 (S24). At this time, the second threshold temperature determining section 33b immediately determines that the second threshold-use thermal fuse 29 has melted, sets a determination time at which the determination has been made by the second threshold temperature determining section 33b to t02, and stores the determination time in the second storage section 27 (S23).

Then, on the basis of the fact that there has been a change from the first threshold temperature Th1 at the determination time t01 to the second threshold temperature Th2 at the determination time t02, a temperature gradient k per unit time is calculated (S26). As illustrated in Fig. 8, the temperature gradient k can be determined by:

$$\text{Temperature gradient } k = (Th2 - Th1) / (t02 - t01)$$
$$= (Th2 - Th1) / ta$$

Then, it is determined whether the temperature gradient k exceeds a threshold gradient Thk (S27). In Embodiment 2, the threshold gradient Thk is assumed to be, for example, threshold gradient Thk = 4 (°C/sec). This is because, as illustrated in (a) and (b) of Fig. 4, the temperature gradient of the internal temperature in the case where fire has broken out from outside the energy meter main body 10 is 5 (°C/sec), and the temperature gradient of the internal temperature in the case where fire has broken out from inside the energy meter main body 10 is 2 (°C/sec). Note that the temperature gradient of the internal temperature illustrated in (a) and (b) of Fig. 4 is an example temperature gradient. Therefore, the threshold gradient Thk = 4 (°C/sec) is an example threshold gradient. Alternatively, another value can be employed as the threshold gradient Thk.

Then, in a case where it is determined in the step S27 that the temperature gradient k exceeds the threshold gradient Thk, (i) it is then determined that fire has been set from outside and (ii) "mode=4" is set (S28). Then, the result of the determination is stored as a tamper log in the first storage section 15, and then the result of the determination is transmitted to the external communication section 14 (S29). The external communication section 14 transmits the result of the determination to a terminal device provided outside the energy meter. Note that it is the abnormality determination control section 13c which (i) determines whether the temperature gradient k exceeds the threshold gradient Thk and (ii) determines that fire has been set from outside.

Meanwhile, in a case where it is determined in the step S27 that the temperature gradient k does not exceed the threshold temperature Thk, (i) it is then determined that fire has broken out from inside and (ii) "mode=5" is set (S30). Then, the result of the determination is stored in the first storage section 15, and is then transmitted to the external communication section 14 (S29). The external communication section 14 transmits the result of the determination to a terminal device provided outside the energy meter. Note that it is the abnormality determination control section 13c which (i) determines whether the temperature gradient k exceeds the threshold gradient Thk and (ii) determines that fire has broken out from inside.

With the process above, the administrator can recognize, with use of an in-house terminal device (not illustrated), that fire has broken out from inside the energy meter 1B due to current leakage or the like.

In comparison with the energy meter 1A in accordance with Embodiment 1 in which the internal measurement-use temperature sensor 25 is used, the energy meter 1B in accordance with Embodiment 2, in which the first threshold-use thermal fuse 28 and the second threshold-use thermal fuse 29 are used, makes it unnecessary to, for example, measure temperatures every 5 seconds. This advantageously allows the device and the operation process to be simple.

As described above, the energy meter 1B in accordance with Embodiment 2 includes, as the temperature detecting section, (i) the first threshold-use thermal fuse 28 configured to melt when the internal temperature becomes equal to or higher than the first threshold temperature Th1 and (ii) the second threshold-use thermal fuse 29 configured to melt when the internal temperature becomes equal to or higher than the second threshold temperature Th2. The abnormality determination control section 13c as a determining section determines a rate of rise in the internal temperature from the time at which the first threshold-use thermal fuse 28 has melted and the time at which the second threshold-use thermal fuse 29 has melted.

Specifically, the energy meter 1B includes: a first temperature detecting section configured to detect that the internal temperature of the energy meter main body 10 has reached the preset first threshold temperature Th1; a second temperature detecting section configured to detect that the internal temperature has reached the preset second threshold temperature Th2, which is higher than the first threshold temperature Th1; the abnormality determination control section 13c which serves as the determining section configured to determine, on the basis of results of the detections performed by the first temperature detecting section and the second temperature detecting section, whether the temperature rise in the internal temperature results from a fire outbreak from outside the energy meter main body 10 or a fire outbreak from inside the energy meter main body 10; and the external communication section 14 which serves as a transmitting section configured to transmit a result of the determination made by the abnormality determination control section 13c to an outside entity.

Consequently, even if data on, for example, power consumption charge stored inside the energy meter main body 10 is deleted by the burning of the energy meter 1B, an administrator of the energy meter 1B obtains, through transmission, the result of the determination as to whether the temperature rise in the internal temperature results from a fire outbreak from outside the energy meter main body 10 or a fire outbreak from inside the energy meter main body 10, before the energy meter main body 10 is burned out.

Thus, it is possible to provide the energy meter 1B which can (i) determine whether a temperature rise of the energy meter main body 10 results from a fire outbreak from outside the energy meter main body 10 or a fire outbreak from inside the energy meter main body 10 and (ii) retain a result of the determination.

Note that the administrator of the energy meter can file a claim for damages against a fraudster on the evidence of the result of the determination.

Further, according to the energy meter 1B in accordance with Embodiment 2, the first temperature detecting section includes: the first threshold-use thermal fuse 28 configured to melt when the internal temperature becomes equal to or higher than the first threshold temperature Th1; and the determination data transmitting section 31b which serves as a first threshold temperature determination result transmitting section configured to transmit, to the abnormality determination control section 13c which serves as a determining section, (i) information indicating that the first threshold-use thermal fuse 28 has melted and (ii) a detection time at which the detection has been performed, and the second temperature detecting section includes: the second threshold-use thermal fuse 29 configured to melt when the internal temperature becomes equal to or higher than the second threshold temperature Th2; and the determination data transmitting section 31b which serves as a second threshold temperature determination result transmitting section configured to transmit, to the abnormality determination control section 13c, (i) information indicating that the second threshold-use thermal fuse 29 has melted and (ii) a detection time at which the detection has been performed. The abnormality determination control section 13c determines the temperature gradient k per unit time based on the amount of time elapsed from the first threshold temperature Th1 to the second threshold temperature Th2, and compares the temperature gradient k to the preset threshold gradient Thk to determine whether a temperature rise in the internal temperature results from a fire outbreak from outside the energy meter main body 10 or a fire outbreak from inside the energy meter main body 10.

Thus, in a case where the thermal fuses are used which are a qualitative temperature measuring section, specifically, the abnormality determination control section 13c can transmit, to an outside entity via the external communication section 14, the result of the determination as to whether a temperature rise in the internal temperature results from a fire outbreak from outside the energy meter main body 10 or a fire outbreak from inside the energy meter main body 10.

Further, an energy meter fire outbreak location identification method for identifying whether a location of a fire outbreak on the energy meter 1B, in accordance with Embodiment 2, for accumulating power consumption is outside the energy meter 1B or inside the energy meter 1B includes: a first temperature detecting step of detecting that the internal temperature of the energy meter main body 10 has reached the preset first threshold temperature Th1; a second temperature detecting step of detecting that the internal temperature has reached the preset second threshold temperature Th2, which is higher than the first threshold temperature Th1; a determining step of determining, on the basis of results of the detections performed in the first temperature detecting step and in the second temperature detecting step, whether the temperature rise in the internal temperature results from a fire outbreak from outside the energy meter main body 10 or a fire outbreak from inside the energy meter main body 10; and a transmitting step of transmitting a result of the determination made in the determining step to an outside entity.

This makes it possible to provide the energy meter fire outbreak location identification method which can (i) determine whether a temperature rise of the energy meter main body 10 results from a fire outbreak from outside the energy meter main body 10 or a fire outbreak from inside the energy meter main body 10 and (ii) retain a result of the determination.

The present invention is not limited to the description of the embodiments above, but may be altered by a skilled person within the scope of the claims. Any embodiment based on a proper combination of technical means disclosed in different embodiments is also encompassed in the technical scope of the present invention. Further, it is possible to form a new technical feature by combining the technical means disclosed in the respective embodiments.

As described above, an energy meter in accordance with an aspect of the present invention is an energy meter for accumulating power consumption, including: a temperature detecting section configured to detect a rise in an internal temperature of an energy meter main body; a determining section configured to determine, on a basis of a rate of the rise in the internal temperature, whether the rise in the internal temperature results from a fire outbreak from outside the energy meter main body or a fire outbreak from inside the energy meter main body; and a transmitting section configured to transmit a result of the determination made by the determining section to an outside entity.

Against the fraudulent activity of willfully burning an energy meter to destroy the display section on which an accumulated power consumption is displayed and accumulated power consumption data stored in the energy meter for the purpose of electricity theft, it is important to identify that the energy meter has been burned from outside the energy meter.

Here, the temperature gradient based on a temperature rise in the internal temperature of the energy meter main body in the case where fire has been set to the energy meter from outside the energy meter is greater than the temperature gradient based on a temperature rise in the internal temperature of the energy meter main body in the case where fire has broken out from inside the energy meter.

Thus, in the event of an outbreak of fire on the energy meter, if it is possible to demonstrate that a temperature gradient calculated from the internal temperature of the energy meter main body is greater than a preset threshold temperature gradient, it is possible to prove that the fire broke out from outside the energy meter, and the fraudulent activity of willfully burning the energy meter was committed.

In view of this, in an arrangement in accordance with an aspect of the present invention, the energy meter includes the temperature detecting section configured to detect a rise in the internal temperature of the energy meter main body. Then, the determining section determines whether the rise in the internal temperature results from a fire outbreak from outside the energy meter main body or a fire outbreak from inside the energy meter main body. The result of the determination is transmitted by the transmitting section to an outside administrator or the like.

Consequently, even if data on, for example, power consumption charge stored inside the energy meter main body is deleted by the burning of the energy meter, an administrator of the energy meter obtains, through transmission, the result of the determination as to whether the temperature rise in the internal temperature results from a fire outbreak from outside the energy meter main body or a fire outbreak from inside the energy meter main body, before the energy meter main body is burned out.

Thus, it is possible to provide the energy meter which can (i) determine whether a temperature rise of the energy meter main body results from a fire outbreak from outside the energy meter main body or a fire outbreak from inside the energy meter main body and (ii) retain a result of the determination.

Note that the administrator of the energy meter can file a claim for damages against a fraudster on the evidence of the result of the determination.

In another aspect of the present invention, the energy meter can be arranged, in the above aspect of the present invention, such that in a case where (i) the internal temperature is equal to or higher than a first threshold temperature and (ii) a rate of the rise in the internal temperature exceeds a threshold rate, the determining section determines that the rise in the internal temperature results from a fire outbreak from outside the energy meter main body.

In a case where the energy meter burns, the temperature rise in the internal temperature of the energy meter main body is specifically such that, at a certain temperature or higher temperatures, the temperature gradient based on a temperature rise in the internal temperature of the energy meter main body in the case where fire has been set to the energy meter from outside the energy meter is greater than the temperature gradient based on a temperature rise in the internal temperature of the energy meter main body in the case where fire has broken out from inside the energy meter.

In view of this, in an aspect of the present invention, in a case where (i) the internal temperature is equal to or higher than the first threshold temperature and (ii) a rate of rise in the internal temperature exceeds a threshold rate, the determining section determines that the rise in the internal temperature results from a fire outbreak from outside the energy meter main body.

This makes it possible to determine, on the basis of technical evidence, whether the rise in the internal temperature results from a fire outbreak from outside the energy meter main body or a fire outbreak from inside the energy meter main body.

In another aspect of the present invention, the energy meter can be arranged, in the above aspect of the present invention, such that the temperature detecting section periodically measures the internal temperature, and the transmitting section transmits (i) a measured internal temperature and (ii) a measurement time at which the internal temperature has been measured to an outside entity.

With this arrangement, not only the result of the determination as to whether a temperature rise in the internal temperature results from a fire outbreak from outside the energy meter main body or a fire outbreak from inside the energy meter main body, but also the internal temperature are transmitted. Thus, the administrator can obtain specific information on change in internal temperature.

In another aspect of the present invention, the energy meter can be arranged, in the above aspect of the present invention, such that the temperature detecting section includes: a first threshold thermal fuse configured to melt when the internal temperature becomes equal to or higher than the first threshold temperature; and a second threshold thermal fuse configured to melt when the internal temperature becomes equal to or higher than a second threshold temperature, the determining section determines the rate of the rise in the internal temperature from a time at which the first threshold thermal fuse has melted and a time at which the second threshold thermal fuse has melted.

With this arrangement, it is possible to qualitatively recognize, with use of the first threshold thermal fuse and the second threshold thermal fuse, that the internal temperature becomes equal to or higher than the first threshold temperature and that the internal temperature becomes equal to or higher than the second threshold temperature, respectively.

Then, when the first threshold thermal fuse and the second threshold thermal fuse melt, the determining section determines a rate of rise in the internal temperature from the time at which the first threshold thermal fuse has melted and the time at which the second threshold thermal fuse has melted.

Thus, in a case where the thermal fuses are used which are a qualitative temperature measuring section, specifically, the determining section can transmit, to an outside entity via the transmitting section, the result of the determination as to whether a temperature rise in the internal temperature results from a fire outbreak from outside the energy meter main body or a fire outbreak from inside the energy meter main body.

In another aspect of the present invention, the energy meter is preferably arranged, in the above aspect of the present invention, such that the temperature detecting section detects the internal temperature at intervals of 15 seconds or less.

In a case where an energy meter is burned, a rate of temperature rise per unit time is high. Thus, unless the internal temperature is detected frequently, it is impossible to determine an accurate temperature gradient.

In view of this, in another aspect of the present invention, the temperature detecting section detects the internal temperature at intervals of 15 seconds or less. This makes it possible to determine an accurate temperature gradient and makes it possible to accurately determine whether a temperature rise in the internal temperature results from a fire outbreak from outside the energy meter main body or a fire outbreak from inside the energy meter main body.

In order to solve the above problem, an energy meter fire outbreak location identification method in accordance with an aspect of the present invention is an energy meter fire outbreak location identification method for identifying a location of a fire outbreak on an energy meter for accumulating power consumption, including: a temperature detecting step of detecting a rise in an internal temperature of an energy meter main body; a determining step of determining, on a basis of a rate of the rise in the internal temperature, whether the rise in the internal temperature results from a fire outbreak from outside the energy meter main body or a fire outbreak from inside the energy meter main body; and a transmitting step of transmitting a result of the determination made in the determining step to an outside entity.

This makes it possible to provide the energy meter fire outbreak location identification method which can (i) determine whether a temperature rise of the energy meter main body results from a fire outbreak from outside the energy meter main body or a fire outbreak from inside the energy meter main body and (ii) retain a result of the determination.

Reference Signs List

    1A, 1B: Energy meter
    2: Housing
    3: Display section
    4: LED lamp
    7: Circuit board

10: Energy meter main body
11: Voltage-dividing circuit
12: Power supply circuit
13: First control device
13a: Power amount calculating section
13b: Display control section
13c: Abnormality determination control section (determining section)
13d: External communication control section
14: External communication section (transmitting section)
15: First storage section
20A, 20B: Security sensor
25: Internal measurement-use temperature sensor (temperature detecting section)
28: First threshold-use thermal fuse (temperature detecting section)
29: Second threshold-use thermal fuse (temperature detecting section)
30: Second control device
31: Data communication section
31a: Sensor data acquiring section
31b: Determination data transmitting section (determination result transmitting section)
32, 33: Sensor data determining section
32a, 33a: First threshold temperature determining section
32b: Second temperature determining section
33b: Second threshold temperature determining section

**Claims**

1.  An energy meter for accumulating power consumption, comprising:

    a temperature detecting section configured to detect a rise in an internal temperature of an energy meter main body;
    a determining section configured to determine, on a basis of a rate of the rise in the internal temperature, whether the rise in the internal temperature results from a fire outbreak from outside the energy meter main body or a fire outbreak from inside the energy meter main body; and
    a transmitting section configured to transmit a result of the determination made by the determining section to an outside entity.

2.  The energy meter according to claim 1, wherein in a case where (i) the internal temperature is equal to or higher than a first threshold temperature and (ii) the rate of the rise in the internal temperature exceeds a threshold rate, the determining section determines that the rise in the internal temperature results from a fire outbreak from outside the energy meter main body.

3.  The energy meter according to claim 1 or 2, wherein the temperature detecting section periodically measures the internal temperature, and the transmitting section transmits (i) a measured internal temperature and (ii) a measurement time at which the internal temperature has been measured to an outside entity.

4.  The energy meter according to claim 1 or 2, wherein the temperature detecting section includes: a first threshold thermal fuse configured to melt when the internal temperature becomes equal to or higher than the first threshold temperature; and a second threshold thermal fuse configured to melt when the internal temperature becomes equal to or higher than a second threshold temperature, the determining section determines the rate of the rise in the internal temperature from a time at which the first threshold thermal fuse has melted and a time at which the second threshold thermal fuse has melted.

5.  The energy meter according to any one of claims 1 to 3, wherein the temperature detecting section detects the internal temperature at intervals of 15 seconds or less.

6.  An energy meter fire outbreak location identification method for identifying a location of a fire outbreak on an energy meter for accumulating power consumption, comprising:

a temperature detecting step of detecting a rise in an internal temperature of an energy meter main body;
a determining step of determining, on a basis of a rate of the rise in the internal temperature, whether the rise in the internal temperature results from a fire outbreak from outside the energy meter main body or a fire outbreak from inside the energy meter main body; and
a transmitting step of transmitting a result of the determination made in the determining step to an outside entity.

FIG. 1

(a)

(b)

1A

3

2

4

5

20A

6a 6b 6

25: Internal measurement
   -use temperature
   sensor

20A 7

6

1A

3

2

(c)

20A

30: Second control device

Security sensor

31: Data communication section

13c

Abnormality
determination
control section

AD1

Radio wave sensor

21

31a

AD2

Electrostatic sensor

22

Sensor data
acquiring section

AD3

Magnetic-field
sensor

23

14

External
communication
section

31b

Determination
data transmitting
section

AD4

Acceleration sensor

24

32: Sensor data determining section

AD5

Internal
measurement-use
temperature sensor

25

32a

First threshold
temperature
determining section

32b

Second temperature
determining section

27

Second storage
section
(detection log)

FIG. 2

FIG. 3

（a）

20a  20A

（b）

20a  20A

（c）

20A

（d）

20A

（e）

20A

（f）

20A

（g）

20A

FIG. 4

## FIG. 5

Start

Initialize status flag
mode=0 — S1

Set threshold temperature
to Th=100°C — S2

Wait 5 seconds — S3

5 seconds elapsed? — S4
NO / YES

Obtain internal measurement-use
temperature sensor value
T= current temperature — S5

mode=0? — S6
NO → mode=1? — S10
NO →

YES
Internal temperature T≧Th? — S7
NO

YES
mode=1? YES — S10
T>T1? — S11
NO

YES
T=T2
Set determination time t02 — S12

T=T1
Set determination time t01 — S8

Set mode=1 — S9

Determine temperature gradient in
a period from T1 to T2
k=(T2−T1)/ta — S13

Temperature gradient k exceeds threshold gradient Thk=4? — S14
NO

YES
Determine that fire
has broken out from
outside
Set mode=4 — S15

YES
Determine that fire
has broken out from
inside
Set mode=5 — S17

Store in first storage
section and transmit to
external communication
section — S16

End

FIG. 6

Temperature gradient k=(T2−T1)/(t02−t01)
=(T2−T1)/ta

FIG. 7

FIG. 8

```
                    ┌──────────────┐
                    │    Start     │
                    └──────┬───────┘
                           │
              ┌────────────┴────────────┐
              │  Initialize status flag │  S21
              │        mode=0           │
              └────────────┬────────────┘
                           │
              ┌────────────┴────────────┐
              │     First threshold     │  S22
              │   thermal fuse melts    │
              └────────────┬────────────┘
                           │  S23
              ┌────────────┴────────────┐
              │   Store first threshold │
              │   thermal fuse melting  │
              │        time t01         │
              └────────────┬────────────┘
                           │
              ┌────────────┴────────────┐
              │    Second threshold     │  S24
              │   thermal fuse melts    │
              └────────────┬────────────┘
                           │  S25
              ┌────────────┴────────────┐
              │      Store second       │
              │   threshold thermal     │
              │    fuse melting time    │
              │          t02            │
              └────────────┬────────────┘
              ┌────────────┴────────────┐
              │  Calculate temperature  │  S26
              │       gradient k        │
              │   k=(Th2-Th1)/(t02-t01) │
              └────────────┬────────────┘
```

S27

Temperature gradient k exceeds threshold gradient Thk=4?

NO

YES

S28 Determine that fire has broken out from outside Set mode=4

YES

S30 Determine that fire has broken out from inside Set mode=5

S29 Store in first storage section and transmit to external communication section

End

FIG. 9

Temperature gradient k=(Th2−Th1)/(t02−t01)

Th2

Th1

ta

t01    t02

## INTERNATIONAL SEARCH REPORT

| International application No. |
|---|
| PCT/JP2017/033856 |

**A. CLASSIFICATION OF SUBJECT MATTER**
Int.Cl. G01R11/02(2006.01)i, G01R11/24(2006.01)i, G01R22/06(2006.01)n

According to International Patent Classification (IPC) or to both national classification and IPC

**B. FIELDS SEARCHED**

Minimum documentation searched (classification system followed by classification symbols)
Int.Cl. G01R11/00-11/66, G01R21/00-22/10

Documentation searched other than minimum documentation to the extent that such documents are included in the fields searched
| | |
|---|---|
| Published examined utility model applications of Japan | 1922-1996 |
| Published unexamined utility model applications of Japan | 1971-2017 |
| Registered utility model specifications of Japan | 1996-2017 |
| Published registered utility model applications of Japan | 1994-2017 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2010-19680 A (TOSHIBA CORP.) 28 January 2010, paragraphs [0009], [0034]-[0035], fig. 1 (Family: none) | 1-6 |
| A | CN 203164248 U (BENGEU POWER SUPPLY COMPANY OF ANHUI ELECTRIC POWER CORPORATION) 28 August 2013, abstract column (Family: none) | 1-6 |
| A | JP 2006-4027 A (SHOWA ELECTRIC WIRE & CABLE CO., LTD.) 05 January 2006, paragraph [0038] (Family: none) | 1-6 |
| P, A | WO 2016/181693 A1 (OMRON CORP.) 17 November 2016, paragraph [0115] & JP 2016-217742 A | 1-6 |

☐ Further documents are listed in the continuation of Box C.    ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 24 November 2017 (24.11.2017) | 05 December 2017 (05.12.2017) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010019680 A